# EUROPEAN PATENT SPECIFICATION

(11) **EP 1 839 088 B1**
(45) Date of publication and mention of the grant of the patent: **25.06.2008**
(21) Application number: 05804583.2
(22) Date of filing: 18.10.2005
(51) Int. Cl.: G03F 7/00

(54) **IMPRINT REFERENCE TEMPLATE FOR MULTILAYER OR MULTIPATTERN REGISTRATION AND METHOD THEREFOR**
DRUCKREFERENZVORLAGE ZUR MEHRSCHICHT- ODER MEHRSTRUKTUR-REGISTRATION UND VERFAHREN DAFÜR
FORME DE REFERENCE D'IMPRESSION POUR LE REPERAGE DE COUCHES OU DE MOTIFS MULTIPLES ET PROCEDE ASSOCIE

(30) Priority: 18.01.2005 US 37890
(43) Date of publication of application: 03.10.2007
(73) Proprietor: International Business Machines Corporation, Armonk, NY 10504 (US)
(72) Inventor: COLBURN, Matthew, E., Hopewell Junction, NY 12533 (US); MARTIN, Yves, C., Ossining, NY 10562 (US); RETTNER, Charles, T., San José, CA 95136 (US); VAN KESSEL, Theodore, G., Millbrook, NY 12545 (US); WICKRAMASINGHE, Hematha, K., San José, CA 95120 (US)
(74) Representative: Williams, Julian David
(86) International application number: PCT/US2005/037278
(87) International publication number: WO 2006/078333

(56) References cited:
- US-A1- 2002 115 002
- US-A1- 2004 096 755
- "REGISTERABLE MULTILAYER MASK FABRICATION TECHNIQUE" IBM TECHNICAL DISCLOSURE BULLETIN, IBM CORP. NEW YORK, US, vol. 27, no. 1B, June 1984 (1984-06), pages 686-688, XP002015431 ISSN: 0018-8689

## Description

### FIELD OF THE INVENTION

The present invention generally relates to an imprint reference template and method, and more particularly to an imprint reference template for multilayer or multipattern registration and a method therefor.

### BACKGROUND OF THE INVENTION

Mask fabrication for imprint lithography (and in general, for all types of lithography) involves engraving a mold (or reticle or mask) with patterns that will be transferred onto silicon wafers by the lithography process.

The exact geometrical registration of the pattern is crucial since chips are built layer-by-layer. Each chip layer is a lithographically-defined pattern that must be registered to the previous layer pattern within a tight tolerance over the entire chip area. In today's semiconductor industry, this tolerance is trending to less than 30 nanometers (nm).

Because of this tight tolerance requirement, fabricating a set of masks for each layer of a chip requires high dimensional precision. This precision must be maintained over the entire mask.

Registration within a mask is critical in the sense that component elements printed with successive masks must be placed correctly. It is useful to imagine a semiconductor device as a stack of coins. In this illustration, each lithographic mask layer and associated processing, prints one coin. After several layers, it is desired to have the coins in a stack. If the coins are imagined as having feature dimensions of 50nm, it is clear that in order to form a free standing stack, lateral offsets of any given coin in the stack must be less than the 50nm feature dimension in any direction. Typical tolerances are 20-40% of the feature dimensions. In this illustration, this would correspond to 20nm.

To further extend the illustration, in a chip, it would be desirable to have the coin stacks over the entire chip surface, such that each stack was similarly perfect. In the case of a 2 cm chip, this corresponds to a long range error of 20 nm over a 2 cm distance in any direction or 1 part in 1,000,000.

It is important to note in this illustration that what is most critical is not that a given stack be in a particular location, but that all coins in the stack be similarly placed in whatever location the given stack is in. In other words, if the stack position has some error, then this is tolerable as long as all the coins in the stack have precisely the same position error.

From a fabrication point of view, the issue is that the various components of a device (e.g., fabricated in layers) should be placed properly.

Masks are typically written using e-beam lithography tools. E-beam lithography employs an electron beam to expose a polymer photoresist which is subsequently developed to reveal features that are finally etched into a mask or template for later use in imprint or photolithography. The performance of these tools is judged in terms of the dimensional precision of the lines that are written and the accuracy of their placement on the mask or template. It is the latter that is exemplarily addressed here. E-beam lithography tools are usually limited to 30 nm registration accuracy across the mask which may vary in size from millimeters to 10 centimeters. In local areas however, the tolerance is often much better.

Specifically, a variety of factors allow the e-beam feature placement tolerance in a local area to be better, including the motion of stages. Within the local field of view of the e-beam column, placement accuracy can be much better. Feature registration accuracy varies from tool to tool, but generally a small region that does not require stage motion and is centrally located within the field of view, can be printed more accurately than a large region where the stages must be moved and the pattern stitched.

Hence, in the e-beam printing tools, there is a problem when feature dimensions of 50 nm or less are desired. For example, if one takes an e-beam tool and it is judged by how well one can register a point on one side of the chip to another part of the chip(1-2 cm distance), in an absolute sense it is not very good. As a practical matter, feature placement accuracy over this distance may be worse than 30 nm.

However, over a short distance, the accuracy may be within about 1 nm. While 30 nm may not appear to be much, with present ground rules being 50nm and the total alignment budget being about 20 nm, the total budget may be exhausted before even starting the process.

US 2004/096755 A1 discloses a method of forming masks using a reference template containing alignment features and using lithography to print the reference template on mask blanks of a chip set.

Thus, prior to the present invention, there has been no method which provides adequate multilayer or multipattern registration corresponding to 50nm ground rules.

### SUMMARY OF THE INVENTION

In view of the foregoing and other exemplary problems, drawbacks, and disadvantages of the conventional methods and structures, an exemplary feature of the present invention is to provide a method as claimed in claim 1 for making a mask which employs a reference template to place reference marks against which sub patterns can be aligned.

The invention also provides a corresponding structure, as claimed in claim 6.

Thus, the invention provides a method of mask making which employs a reference template to place reference marks against which sub patterns can be aligned. By using the same reference template for each of the lithographic masks that make up a chip set, placement accuracy can be improved.

In one exemplary non-limiting embodiment, the mask making includes creating a reference template using E-beam lithography. Then, imprint lithography is used to print the reference template alignment marks on all the mask blanks for a given chip set. Finally, sub patterns are printed on each mask blank using e-beam or imprint lithography and aligned to the reference template alignment marks.

Imprint lithography is an inherently 1X process. In addition, imprint lithography faithfully reproduces the mask pattern, often to molecular dimensions. That is, in the context of the present application, the features on the imprint mask (or mold) are the same size, and in the same location as the features printed on the chip.

In an exemplary embodiment of the invention, a reference template is created, with alignment marks for sub patterns, which is then employed to print these marks on all of the subsequent masks that form the chip set.

Hence, the invention provides small patterns ("hooks") or registration pattern, on which can be hung the features, and thus the present invention provides a local reference to enable a much more precise registration. Thus, all regions of all masks are aligned to the same sub pattern reference mask. 5-10 nm alignment accuracy can be achieved in sub pattern registration using Imprint lithography.

Hence, the sub pattern registration accuracy from layer to layer given mask alignment and sub pattern alignment errors would be (to first order) root(sqr(5)+sqr(5)) or approximately 7nm in the best case, if imprint lithography were to be used to print the patterns. This is consistent with 35 nm ground rules. Presently, 90nm is the norm.

The template, accurately propagated on each mask of one set, thus provides for accurate registration of the sub patterns on each mask. The fact that the same reference template is reproduced on all masks using imprint lithography makes this possible. It is noted that the subpatterns can be printed using imprint or e-beam as each case dictates.

### BRIEF DESCRIPTION OF THE DRAWINGS

The foregoing and other exemplary purposes, aspects and advantages will be better understood from the following detailed description of an exemplary embodiment of the invention with reference to the drawings, in which:
Figure 1 illustrates a reference template 100 with registration marks 110;
Figure 2 illustrates a structure 200 for replicating the registration marks for each level mask 210, 220, 230, etc.;
Figure 3 illustrates a usage of structure 300 for adding subarray patterns for each mask;
Figure 4 illustrates a flowchart of a method 400 according to the present invention; and
Figure 5 illustrates a functional block diagram of a system 500 for forming a plurality of masks.

### DETAILED DESCRIPTION OF EXEMPLARY EMBODIMENTS OF THE INVENTION

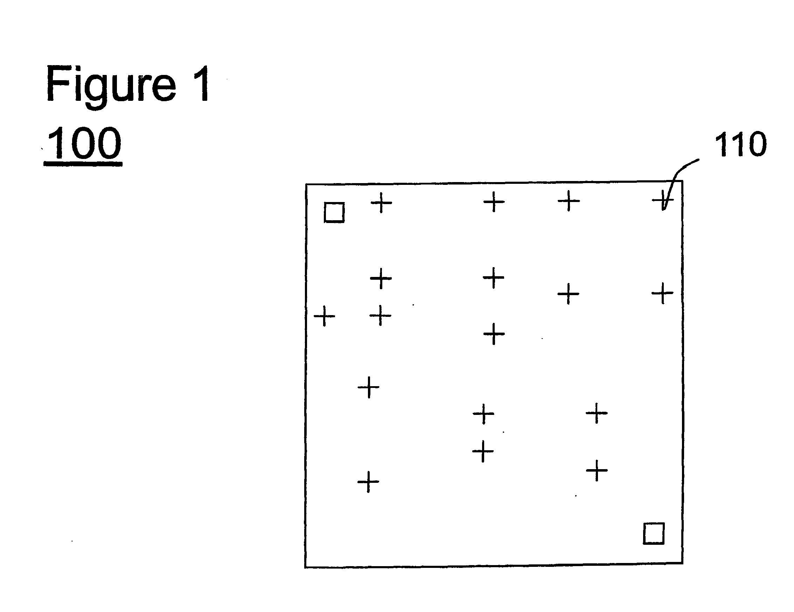

Referring now to the drawings, and more particularly to Figures 1-5, there are shown exemplary embodiments of the method and structures according to the present invention.

### EXEMPLARY EMBODIMENT

The present inventors have recognized that an important implication of the above-described conventional methods and problems is that it is difficult or impossible to write the same mask twice using conventional methods involving e-beam. Further, using conventional optical lithography to print a master pattern on a mask can compound the problem with magnification and other distortion errors. In view of this, the present invention takes advantage of imprint lithography.

Imprint lithography refers to a process where features are etched into a template or mold forming a relief pattern. A polymer photoresist is applied to a substrate and the mold is pressed into the polymer. The mold is usually made of a transparent material such as quartz. Light is passed through the mold or substrate to cure the photoresist and the mold is removed, leaving behind the complementary pattern of the mask features in the cured photoresist. This resist is subsequently etched to transfer the patterns to the substrate.

A key attribute of the imprint lithography process is that from one print to the next, the mold reproduces the features very accurately with respect to size and most importantly in this context, with respect to placement accuracy. With proper attention to temperature, long range accuracy on the order of nanometers is possible with imprint lithography.

It is noted that imprint lithography can be practiced in many varied forms similar to the above. Thus, the present invention generically uses imprint lithography and specifically it is the use of a rigid mold that applies to the present invention.

Figure 1 illustrates a template 100 for use with the invention. The template 100 possesses at least one registration mark 110 (preferably a plurality of registration marks), both for the optical alignment marks, and for sub-array components that make up the mask pattern.

The mark(s) 110 can be any one or more boxes, crosses, or any type of alignment mark selected for optimum alignment of sub-array patterns described below. Figure 1 shows an example on a square glass mold, for nano-imprint lithography. Other materials could be used for the template 100 such as quartz, sapphire etc.

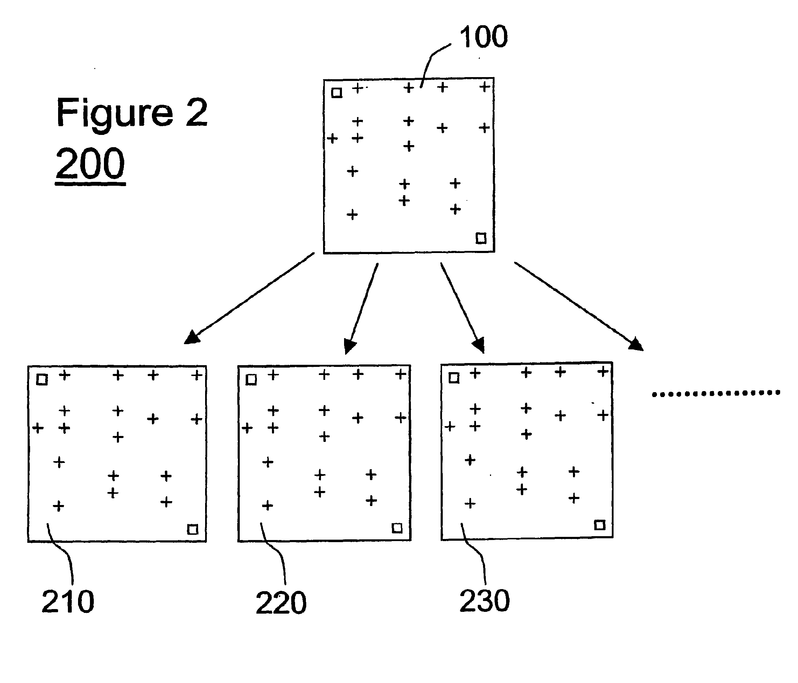

As shown in Figure 2, the mark(s) 110 of the template 100 are faithfully propagated (printed) in the mask substrate 210, 220, 230, etc. for each level. Though various types of lithography (e.g., optical, direct write optical or e-beam) can be used for this process, nano-imprint is ideally suited for this purpose because the marks are faithfully replicated into daughter molds, which will become the masks for each level of the chip.

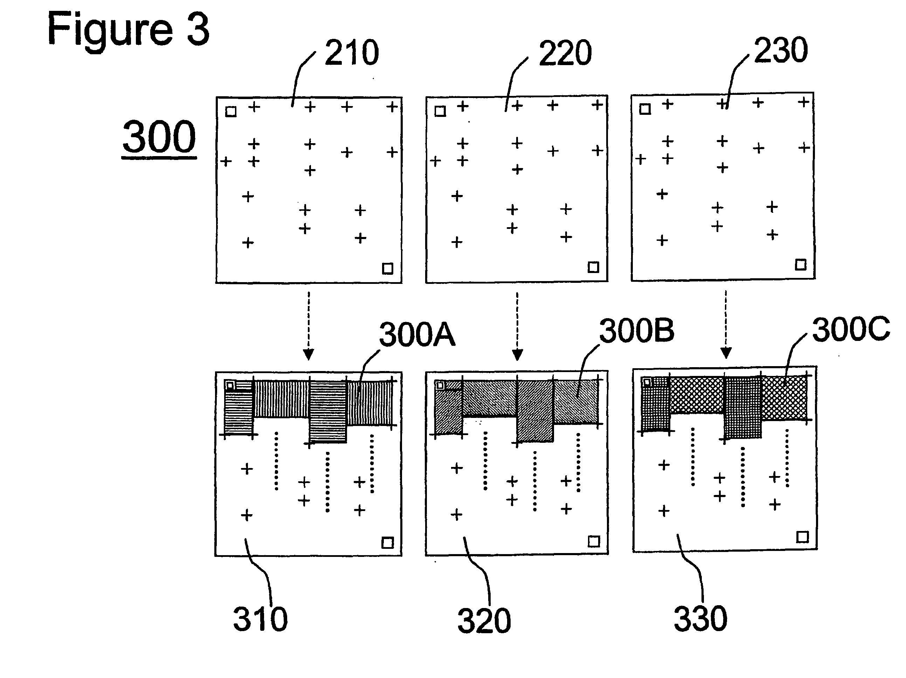

Turning to Figure 3, the sub-array patterns 300A, 300B, 300C for each layer are generated and aligned to the reference template (210, 220 or 230).

Each layer contains patterns one of 300A, 300B, 300C, etc. that are placed and aligned relative to the corresponding alignment template (210, 220 or 230) in this illustration Figure 3 shows multiple sub patterns in each of 310, 320 and 330. Each of the individual subpatterns is aligned to the reference pattern. In an actual microprocessor chip, each of the subpattern areas might correspond to a functional group such as cache memory, CPU etc. From mask to mask, the corresponding subpatterns correspond to the individual components of the functional group such as transistor gates, contacts etc. These are formed on each mask that contains the registration mark(s) 110 using some type of lithographic process, for example optical, e-beam, or nano-imprint lithography.

Thus, sub-array patterns are added for each mask. The registration mark(s) allow for precise alignment of each sub-array.

The generation and propagation of registration marks from the same template 100 provides a set of mask substrates 210, 220, 230, etc. that are very identical (for purposes of the invention, "very identical" means that the features are positioned and sized identically within a given mask substrate relative to any of the other mask substrates such that if it were possible to place and align the patterns of each mask template on top of one another no differences could be observed). The placement of the registration mark(s) is identical on each level mask. The use of these mark(s) allows for precise positioning of each sub-array pattern 300A, 300B, 300C, etc. for each level.

Propagating the marks by nano-imprint has many advantages. For example, using the same lithography process to produce the masks as well as the wafers is cost effective. Hence, one takes advantage of tooling and technology developed for large-scale lithography.

Additionally, propagating the marks "at dimension" (e.g., 1X magnification) is more reliable, compared to a lithographic technique that uses variable magnification. That is, no distortion is introduced into the imaging process by any magnification, etc.

Further, using imprint lithography, typically no calibration or adjustment of relative "write positions" are required, such as in e-beam lithography.

Additionally, higher resolution is available by nano-imprint than by current optical lithography. More specifically, imprint lithography has been demonstrated to 5 nm features.

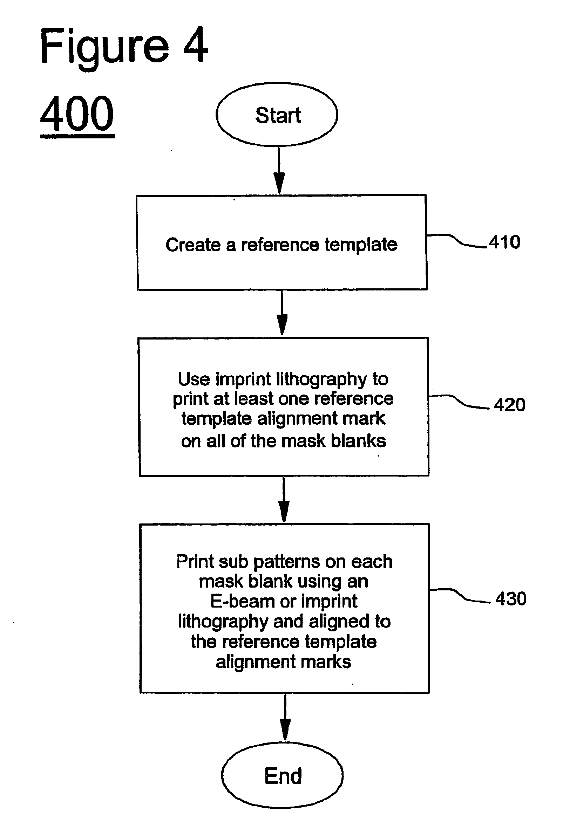

Turning now to Figure 4, a flowchart of a method 400 according to the present invention, will be described.

Specifically, in step 410, a reference template is created, using, for example, e-beam lithography.

Then, in step 420, imprint lithography is used to print at least one (and more preferably a plurality) reference template alignment mark(s) on all of the mask blanks for a given chip set.

Finally, in step 430, sub patterns are printed on each mask blank using, for example, e-beam or imprint lithography, and aligned to the reference template alignment mark(s).

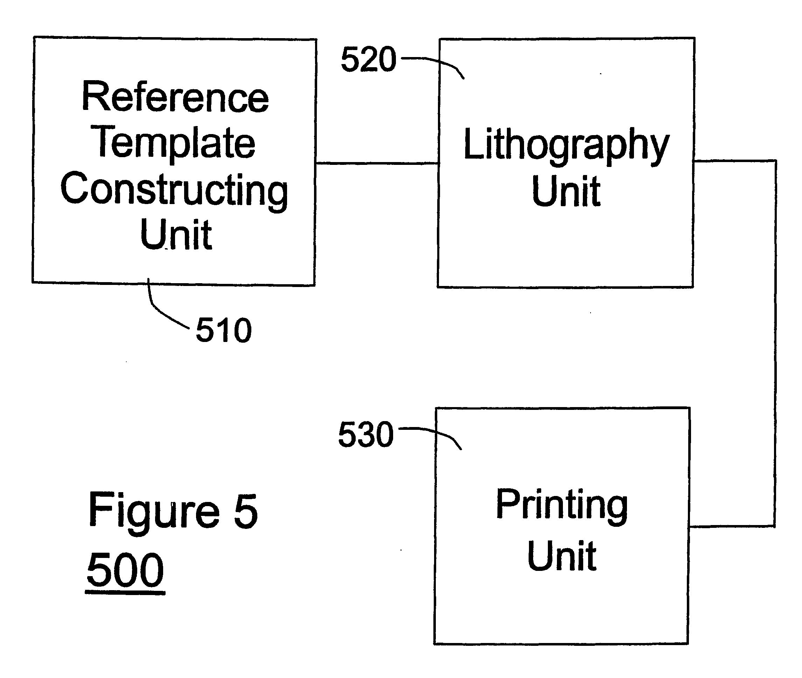

Figure 5 illustrates a system for forming a plurality of masks, which includes a reference template constructing unit 510 which creates a reference template containing one or more alignment features.

A lithography system 520 (e.g., e-beam lithography or imprint lithography) is used to print at least one copy of the reference template on all of a plurality of mask blanks for a given chip set.

Thereafter, a printing unit 530 prints sub-patterns on each of the plurality of mask blanks, and aligns the sub-patterns to the at least one reference template alignment mark.

As should be clear from the above, the invention is advantageous in making a mask, but also is advantageous in chip-making (e.g., assembling layers on a chip). Thus, the invention can provide registration in both the horizontal plane and in the vertical plane. With the reference pattern(s), a given layer can be made more accurate, or subsequent layers (e.g., of a multilayer chip for example) can be made more accurate.

It is noted that the reference patterns need not be arranged strictly in a grid pattern or any predetermined pattern for that matter, but may have any pattern suitable to the chip or device being constructed.

It is noted in particular that the term "alignment mark" or "alignment feature" is used in the present description to refer to any mark or feature used to perform subsequent alignment. Crosses, "L" patterns, boxes etc. are typical forms but by no means exhaustive.

## Claims

1. A method of forming a plurality of masks, comprising the step of:
creating (410) a reference template containing one or more alignment marks, **characterised in that** the method comprises the further steps of:
using (420) lithography to print at least one copy of said reference template on all of a plurality of mask blanks for a given chip set wherein said copy uses imprint lithography to copy the reference template to the mask blanks; and
printing (430) sub-patterns on each of said plurality of mask blanks, and aligning the sub-patterns to the at least one reference template alignment mark.

2. The method of claim 1, wherein said creating comprises creating a reference template using electron-beam lithography.

3. The method of claim 1, wherein said printing sub-patterns comprises using at least one of electron-beam lithography and imprint lithography.

4. The method of claim 1, wherein the reference template comprises one of a glass mold, a quartz mold, a sapphire mold and a silicon mold, for nano-imprint lithography.

5. The method of claim 1, wherein each layer contains patterns grouped in sub-arrays, and
wherein said patterns are formed on each mask that contains the registration mark using at least one of optical lithography, electron-beam lithography, and nano-imprint lithography, and
wherein the registration mark allows for precise alignment of each sub-array,
wherein placement of the registration mark is identical on each level mask

6. A system for forming a plurality of masks, comprising:
a reference template (100) containing one or more alignment marks;
a lithography system (520) to print at least one copy of said reference template on all of a plurality of mask blanks for a given chip set wherein said lithography system comprises an imprint lithography system to copy the reference template to the mask blanks; and
a printer (530) that prints sub-patterns on each of said plurality of mask blanks, and aligning the sub-patterns to the at least one reference template alignment mark.

7. The system of claim 6, wherein the at least one reference template mark is for optical alignment marks, and for sub-array components that make up the mask pattern.

8. The system of claim 6, wherein the at least one reference template mark is for direct write optical alignment, and for sub-array components that make up the mask pattern.

9. The system of claim 6, wherein the reference template comprises one of a glass mold, a quartz mold, a sapphire mold and a silicon mold, for nano-imprint lithography.

10. The system of claim 6, wherein each layer contains patterns grouped in sub-arrays, and
wherein said patterns are formed on each mask that contains the registration mark using at least one of optical lithography, electron-beam lithography, and nano-imprint lithography, and
wherein the registration mark allows for precise alignment of each sub-array,
wherein placement of the registration mark is identical on each level mask.

## Patentansprüche

1. Verfahren zum Herstellen einer Vielzahl von Masken, das den folgenden Schritt umfasst:
Erzeugen (410) einer Referenzschablone (reference template), die eine oder mehrere Ausrichtungsmarkierungen (alignment marks) enthält,
**dadurch gekennzeichnet, dass** das Verfahren die folgenden weiteren Schritte umfasst:
Verwenden (420) von Lithografie zum Drucken von mindestens einer Kopie der Referenzschablone auf alle aus einer Vielzahl von Maskenrohlingen (mask blanks) für einen gegebenen Chipsatz, wobei die Kopie Imprint-Lithografie (imprint lithography) zum Kopieren der Referenzschablone auf die Maskenrohlinge verwendet; und
Drucken (430) von Teilmustern auf jeden aus der Vielzahl von Maskenrohlingen und Ausrichten der Teilmuster an der mindestens einen Referenzschablonen-Ausrichtungsmarkierung.

2. Verfahren nach Anspruch 1, wobei das Erzeugen das Erzeugen einer Referenzschablone unter Verwendung von Elektronenstrahl-Lithografie umfasst.

3. Verfahren nach Anspruch 1, wobei das Drucken von Teilmustern zumindest das Verwenden von Elektronenstrahl-Lithographie oder von Imprint-Lithografie umfasst.

4. Verfahren nach Anspruch 1, wobei die Referenzschablone eine Glasform, eine Quarzform, eine Saphirform oder eine Siliziumform für Nano-Imprint-Lithografie umfasst.

5. Verfahren nach Anspruch 1, wobei jede Schicht in Teilbereiche gruppierte Muster enthält, und
wobei die Muster auf jeder Maske gebildet werden, die die Registrierungsmarkierung enthält, wobei zumindest optische Lithografie, Elektronenstrahl-Lithografie oder Nano-Imprint-Lithografie verwendet wird, und
wobei die Registrierungsmarkierung eine genaue Ausrichtung jedes Teilbereichs ermöglicht,
wobei das Platzieren der Registrierungsmarkierung auf jeder Ebenenmaske identisch ist.

6. System zum Herstellen einer Vielzahl von Masken, das Folgendes umfasst:
eine Referenzschablone (100), die eine oder mehrere Ausrichtungsmarkierungen enthält;
ein Lithografiesystem (520) zum Drucken von mindestens einer Kopie der Referenzschablone auf alle aus einer Vielzahl von Maskenrohlingen für einen gegebenen Chipsatz, wobei das Lithografiesystem ein Imprint-Lithografiesystem umfasst, um die Referenzschablone auf die Maskenrohlinge zu kopieren; und
einen Drucker (530), der Teilbereiche auf jeden aus der Vielzahl von Maskenrohlingen druckt, und wobei die Teilbereiche an der mindestens einen Referenzschablonen-Ausrichtungsmarkierung ausgerichtet werden.

7. System nach Anspruch 6, wobei die mindestens eine Referenzschablonenmarkierung für optische Ausrichtungsmarkierungen und für Teilbereichkomponenten, die das Maskenmuster ausmachen, vorgesehen ist.

8. System nach Anspruch 6, wobei die mindestens eine Referenzschablonenmarkierung für optische Ausrichtung mit direktem Schreiben und für Teilbereichkomponenten, die das Maskenmuster ausmachen, vorgesehen ist.

9. System nach Anspruch 6, wobei die Referenzschablone eine Glasform, eine Quarzform, eine Saphirform oder eine Siliziumform für Nano-Imprint-Lithografie umfasst.

10. System nach Anspruch 6, wobei jede Schicht in Teilbereiche gruppierte Muster enthält, und
wobei die Muster auf jeder Maske gebildet werden, die die Registrierungsmarkierung enthält, wobei zumindest optische Lithografie, Elektronenstrahl-Lithografie oder Nano-Imprint-Lithografie verwendet wird, und
wobei die Registrierungsmarkierung eine genaue Ausrichtung jedes Teilbereichs ermöglicht,
wobei das Platzieren der Registrierungsmarkierung auf jeder Ebenenmaske identisch ist.

## Revendications

1. Un procédé de formation d'une pluralité de masques, comprenant l'étape consistant à :
créer (410) un modèle de référence contenant une ou plusieurs marques d'alignement,
**caractérisé en ce que** le procédé comprend les étapes supplémentaire consistant à :
utiliser (420) une lithographie pour imprimer au moins une copie dudit modèle de référence sur la totalité d'une pluralité d'ébauches de masques, pour un jeu de puces donné, dans lequel ladite copie utilise une lithographie d'impression pour copier le modèle de référence sur les ébauches de masques ; et
imprimer (430) des sous-motifs sur chacune de ladite pluralité des ébauches de masque, et aligner les sous-motifs sur la au moins une marque d'alignement de modèle de référence.

2. Le procédé selon la revendication 1, dans lequel ladite création comprend la création d'un modèle de référence, par utilisation d'une lithographie à faisceau d'électrons.

3. Le procédé selon la revendication 1, dans lequel l'impression des sous-motifs comprend l'utilisation d'au moins une lithographie à faisceau d'électrons et une lithographie d'impression.

4. Le procédé selon la revendication 1, dans lequel le modèle de référence comprend l'un, parmi un moule en verre, un moule en quartz, un moule en saphir et un moule en silicum, pour une lithographie de nanoimpression.

5. Le procédé selon la revendication 1, dans lequel chaque couche contient des motifs, groupés en sous-zones, et
dans lequel lesdits motifs sont formés sur chaque masque contenant la marque d'alignement, en utilisant au moins l'une d'une lithographie optique, d'une lithographie à faisceau d'électrons, et d'une lithographe de nanoimpression, et
dans lequel la marque d'alignement permet un alignement précis de chaque sous-zone,
dans lequel le placement de la marque d'alignement est identique sur chaque masque de niveau.

6. Un système de formation d'une pluralité de masques, comprenant :
un modèle de référence (100) contenant une ou plusieurs marques d'alignement,
un système de lithographie (520), pour imprimer au moins une copie dudit modèle de référence sur la totalité d'une pluralité d'ébauches de masques, pour un jeu de puces donné, dans lequel ledit système de lithographie comprend un système de lithographie d'impression, pour copier le modèle de référence sur les ébauches de masques ; et
une imprimante (530) imprimant des sous-motifs sur chacune de ladite pluralité des ébauches de masque, et l'alignement des sous-motifs sur la au moins une marque d'alignement de modèle de référence.

7. Le système selon la revendication 6, dans lequel la au moins une marque d'alignement de modèle de référence vaut pour des marques d'alignement optiques, et pour des composants de sous-zones constituant le motif de masque.

8. Le système selon la revendication 6, dans lequel la au moins une marque d'alignement de modèle de référence vaut pour un alignement optique à écriture directe, et pour des composants de sous-zones constituant le motif de masque.

9. Le système selon la revendication 6, dans lequel le modèle de référence comprend l'un, parmi un moule en verre, un moule en quartz, un moule en saphir et un moule en silicum, pour une lithographie de nanoimpression.

10. Le système selon la revendication 6, dans lequel chaque couche contient des motifs, groupés en sous-zones, et
dans lequel lesdits motifs sont formés sur chaque masque contenant la marque d'alignement, en utilisant au moins l'une d'une lithographie optique, d'une lithographie à faisceau d'électrons, et d'une lithographe de nanoimpression, et
dans lequel la marque d'alignement permet un alignement précis de chaque sous-zone,
dans lequel le placement de la marque d'alignement est identique sur chaque masque de niveau.
